# EUROPEAN PATENT SPECIFICATION

(11) **EP 0 577 188 B1**
(45) Date of publication and mention of the grant of the patent: **01.09.1999**
(21) Application number: 93201805.4
(22) Date of filing: 22.06.1993
(51) Int. Cl.: G01R 33/56

(54) **Method and apparatus for magnetic resonance imaging**
Verfahren und Gerät zur Kernresonanzabbildung
Procédé et appareil d'imagerie par résonance magnétique

(30) Priority: 29.06.1992 EP 92201926
(43) Date of publication of application: 05.01.1994
(73) Proprietor: Koninklijke Philips Electronics N.V., 5621 BA Eindhoven (NL)
(72) Inventor: van der Meulen, Peter, NL-5656 AA Eindhoven (NL); van Yperen, Gerrit Hendrik, NL-5656 AA Eindhoven (NL)
(74) Representative: Schouten, Marcus Maria

(56) References cited:
- EP-A- 0 204 320
- EP-A- 0 210 562
- EP-A- 0 309 720
- EP-A- 0 310 434
- MAGNETIC RESONANCE IN MEDICINE. vol. 20, no. 2, 1 August 1991, DULUTH,MN US pages 268 - 284 CH. BOESCH ET AL. 'TEMPORAL AND SPATIAL ANALYSIS OF FIELDS GENERATED BY EDDY CURRENTS IN SUPERCONDUCTING MAGNETS: OPTIMIZATION OF CORRECTIONS AND QUANTITATIVE CHARACTERIZATION OF MAGNET/GRADIENT SYSTEMS'
- JOURNAL OF MAGNETIC RESONANCE. vol. 97, no. 3, 1 May 1992, ORLANDO, MN US pages 661 - 665 S. CROZIER ET AL. 'CORRECTION OF EDDY-CURRENT-INDUCED B0 SHIFTS BY RECEIVER REFERENCE-PHASE MODULATION'

## Description

The invention relates to a method for magnetic resonance imaging as defined in the preamble of claim 1. The invention also relates to an apparatus for magnetic resonance imaging using such a method.

Such method and apparatus for imaging are known from EP-A 0 309 720. In the known method switched gradient magnetic fields are applied for encoding position information in the NMR-signals. The gradient fields provide slice selection, phase encoding and read gradients. As described in the cited EP-A 0 309 720, switching of the gradients causes eddy currents in the apparatus, which eddy currents generate magnetic fields of their own and disturb the applied magnetic fields, thereby affecting the phases of the precessing nuclear spins of a body to be examined and causing artefacts in a reconstructed image. Such artefacts may exhibit themselves as local low contrast, local absence of signal in an image or the presence of ghosts in the image. In the known method and apparatus the influence of eddy currents in a spin-echo sequence is reduced by changing the main magnetic field by means of energising an auxiliary coil during a short interval in between the RF-pulses. The strength of the field generated by the auxiliary coils is made proportional to the strength of one of the gradient fields.

A disadvantage of the known method is the necessity to provide the magnetic resonance imaging (MRI) device with auxiliary coils. A further disadvantage is that the modification of the main magnetic field relates to the strength of one gradient field, that it is applied to the whole volume and not adjusted for spatial variations of the effect of the eddy currents.

From J.Magn.Res, 97 (1992) 661-665 a method of correction of eddy-current-induced Bₒ shifts by receiver or transmitter reference-phase modulation is known.

It is, *inter alia*, an object of the invention to provide a magnetic resonance method in accordance to the introductory paragraph in which effects of eddy currents and other disturbances caused by the apparatus, such as phase-distortion in the RF-pulses, are reduced without providing additional coils and in a manner that allows spatial variation of such effects taken into account.

Thereto, the method according to the invention is defined in claim 1. The initial stage, or setting up stage, of a sequence is the portion preceding the occurrence and acquisition of the NMR-signals, the latter stage can be referred to as the acquisition stage. An adaption in either stage in a measuring sequence can be done by using the capability of MRI devices generating gradient fields and RF-pulses at almost arbitrary strength and with large flexibility. The invented method uses these built-in features. In the preparatory sequence the effect of the disturbances upon the magnetic resonance signals is determined so that subsequent compensation in the measuring sequence can be achieved. As the disturbing effects, such as eddy currents and distortion in RF-pulse generating means, are constant in the acquisition stage, adjustment is necessary in the initial stage only. However, it is possible to keep the initial stage unchanged but to adjust the acquisition phase with equivalent effect, or to distribute the adjustment in both stages. The preparatory sequence does not need to be identical with a measuring sequence. Differences between the preparatory sequence and a measuring sequence are acceptable if the differences do not give rise to a net contribution of disturbances such as eddy currents and RF-pulse phase distortion.

In a measuring sequence according to the invention the amount of the adjustment of the initial stage relative to the acquisition stage is dependent on the phases of magnetic resonance signals in the preparatory sequence. This measure allows compensation for disturbances that affect the phases of the precessing spins in a portion of the body collectively. Such disturbances are, for example, phase-distortion in the RF-pulse generating chain or deviations in gradient magnetic fields applied for the selection of a slice from the body, deviations that are, for example, due to eddy currents.

In the method according to the invention the preparatory sequence is applied for generating at least a first and a second magnetic resonance signal and the amount of the adjustment is proportional to the phase difference between said first and second magnetic resonance signals. This allows an accurate compensation if the required correction is linear with the size of the disturbance.

In the method according to the invention the initial stage of a measuring sequence is adjusted by adapting the phase of the excitation RF-pulse or by adapting the phases of the refocusing RF-pulses. This provides a possibility for correction in case of phase-distortion of the RF-pulses. for example due to imperfection in the RF-pulse generation chain.

An embodiment of the method according to the invention is characterised in that at least two different slices of the body are selected and in that the initial stage or the acquisition stage of the measuring sequences are adjusted for each selected slice separately. In this embodiment several slices are imaged, and the compensation is optimised for each of the slices individually. This takes into account that disturbances may have different effects at different positions of the body.

The invention also relates to an apparatus for performing such a method. An apparatus according to the invention is defined in Claim 3.

These, and other more detailed aspects of the invention will now be elucidated by way of example with reference to the accompanying drawings.

The drawings show in
Figure 1 diagrammatically a magnetic resonance imaging apparatus, suitable for the method according to the invention;
Figure 2 a sequence comprising an excitation RF-pulse, a plurality of refocusing RF-pulses, gradient magnetic fields and the occurrence of spin-echo signals as a function of time;
Figures 3a and 3b a preparatory sequence and a measuring sequence both comprising an excitation RF-pulse, a plurality of refocusing RF-pulses, gradient magnetic fields and spin-echo signals as a function of time according to an embodiment of the invention;
Figure 4 a measuring sequence illustrating a three-dimensional imaging method.

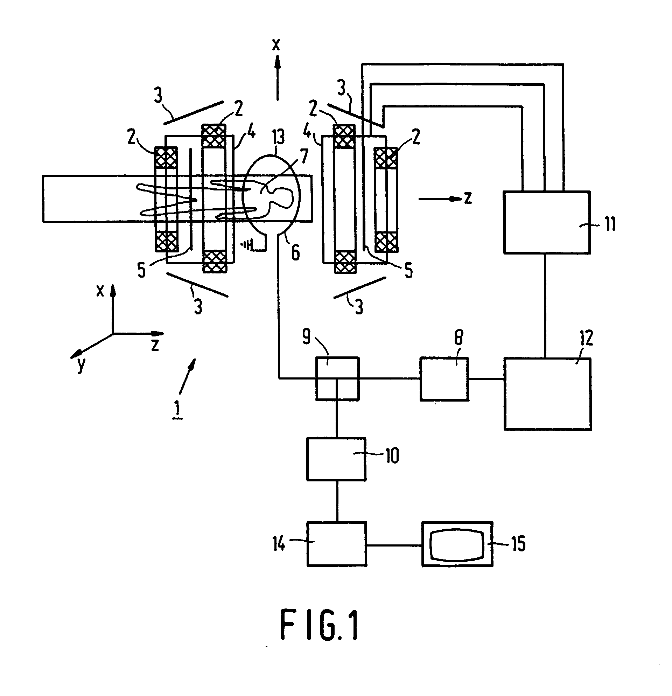

In Figure 1 a magnetic resonance apparatus 1 is diagrammatically shown.The apparatus comprises a set of main magnetic coils 2 for generating a stationary homogeneous main magnetic field and several sets of gradient coils 3, 4 and 5 for superimposing additional magnetic fields with controllable strength and having a gradient in a selected direction. Conventionally, the direction of the main magnetic field is labelled the *z* direction, the two directions perpendicular thereto the *x* and *y* directions. The gradient coils are energised *via* a power supply 11. The apparatus further comprises emitting means 6 for emitting radio-frequency pulses (RF-pulses) to an object or body 7, the radiation means being coupled to modulating means 8 for generating and modulating of the RF-pulses. Also provided are means for receiving the NMR-signals, these means can be identical to the emitting means 6 or be separate. If the emitting and receiving means are identical, as shown in the Figure, a send-receive switch 9 is arranged to separate the received signals from the pulses to be emitted. The received NMR-signals are input to receiving and demodulating means 10. The emitting means 6 and 8 and the power supply 11 for the gradient coils 3, 4 and 5 are steered by a control system 12 to generate a predetermined sequence of RF-pulses and gradient field pulses. The demodulation means is coupled to a data processing unit 14, for example a computer, for transformation of the received signals into an image that can be made visible, for example on a visual display unit 15.

If the magnetic resonance apparatus 1 is put into operation with an object or body 7 placed in the magnetic field, a small excess of nuclear dipole moments (nuclear spins) in the body will be aligned in the direction of the magnetic field. In equilibrium, this causes a net magnetisation **M**_{**0**} in the material of the body 7, directed in parallel with the magnetic field. In the apparatus 1 the macroscopic magnetisation **M**_{**0**} is manipulated by radiating to the body RF-pulses having a frequency equal to the Larmor frequency of the nuclei, thereby bringing the nuclear dipole moments in an excited state and re-orienting the magnetisation **M**_{**0**}. By applying the proper RF-pulses, a rotation of the macroscopic magnetisation is obtained, the angle of rotation is called the flip-angle. The intentional introduction of variations in the magnetic field by applying gradient magnetic fields influences the behaviour of the magnetisation locally. After the application of RF-pulses, the changed magnetisation will strive to return to a state of thermal equilibrium in the magnetic field, emitting radiation in the process. A well chosen sequence of RF-pulses and gradient field pulses causes this radiation to be emitted as NMR-signals which provide information about the density of a certain type of nuclei, for example hydrogen nuclei, and the substance in which they occur. By analysis of the emitted signals and presentation of it in the form of images, information about the internal structure of the object or body 7 is accessible. For a more detailed descriptions of magnetic resonance imaging (MRI) and MRI-devices reference is made to the extensive literature on this subject, for example to the book "Practical NMR Imaging", edited by M.A. Foster and J.M.S. Hutchinson, 1987, IRL Press.

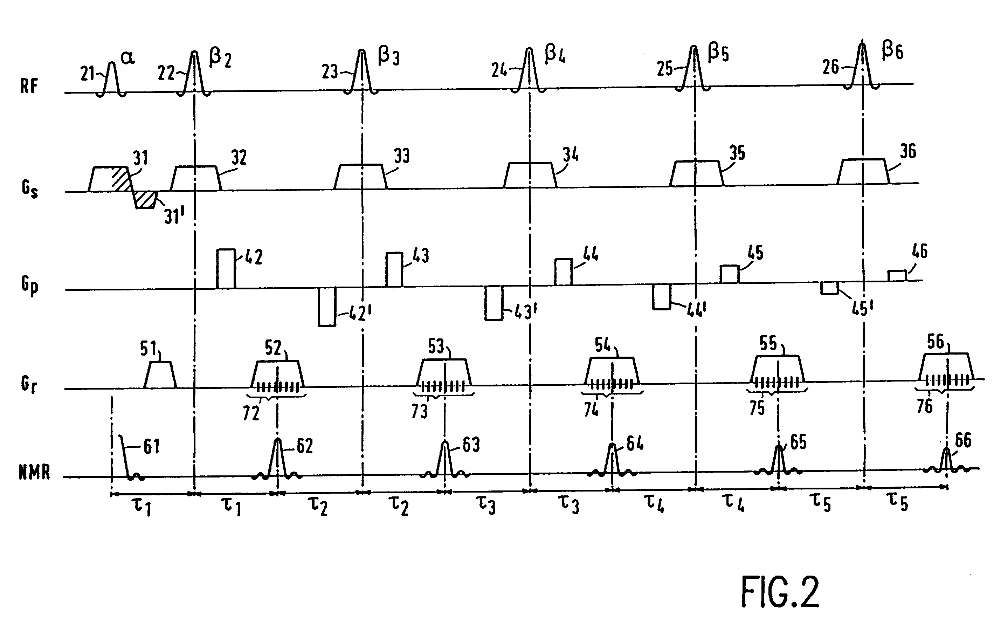

Figure 2 shows a sequence of RF-pulses and magnetic field gradients for obtaining multiple spin-echo NMR-signals Following a single excitation pulse. In the upper line RF the start of the sequence is indicated with an excitation RF-pulse 21 having a flip-angle α, followed after an interval τ₁ by a first refocusing RF-pulse 22 having a flip-angle β₂. Normally, the values of α and β₂ are 90° and 180°, respectively. Following the excitation RF-pulse 21, a free induction decay (FID) nuclear magnetic resonance signal 61, indicated on the lower line NMR, is generated which vanishes rapidly when the individual precessing nuclear magnetic dipole moments lose phase coherence due to local variations in the magnetic field. The refocusing RF-pulse 22 reverses the direction of these individual magnetic dipole moments without affecting the local magnetic field. Consequently, the dephasing is reversed into a rephasing resulting after an equal interval τ₁ in the occurrence of a NMR spin-echo signal 62. After the spin-echo signal 62 the dipole moments dephase again. Repetition of refocusing RF-pulses 23, 24, 25 and 26, with flip-angles βᵢ, i = 3, ..., 6, normally also of 180°, cause subsequent reversals of the dephasing and the repeated occurrence of NMR spin-echo signals 63, 64, 65 and 66. The interval lengths τ₂, τ₃, τ₄ and τ₅ between a spin-echo signal and the next refocusing RF-pulse are normally chosen to be equal in length.

The effect of the RF-pulses is made selective to a portion of the body 7 by applying, for example, simultaneously with the RF-pulses a slice selection gradient, which is indicated on the second line Gₛ in the Figure. As indicated by 31 the slice selection gradient is first applied during the excitation RF-pulse 21. The dephasing caused by this first gradient 31 is compensated by an opposite gradient 31'. Also during the application of the refocusing RF-pulses 22-26 slice selection gradients 32-36 are switched on. For position determination within the selected slice, phase encoding gradient pulses 42, 43, 44, 45 and 46 with the gradient direction within the selected slice, indicated on the third line Gₚ, are applied in the interval between the RF-pulse and the NMR spin-echo signals 62, 63, 64, 65 and 66. In addition, frequency encoding or read gradients 52, 53, 54, 55 and 56, indicated on the fourth line Gᵣ, having a gradient direction also within the selected slice but perpendicular to the gradient direction of the phase encoding field, are switched on during the occurrence of the spin-echo signals. The dephasing effects of the phase encoding gradients is removed after the occurrence of the spin-echo signals by applying further gradient pulses 42', 43', 44', 45' with the same size but with the gradient direction opposite compared to the preceding gradient pulses 42, 43, 44, 45, respectively. The dephasing effect of the read gradients 52, 53, 54, 55 and 56 is compensated for by the refocusing RF-pulses. A compensation read gradient 51, applied in the interval in between the excitation RF-pulse 21 and the first refocusing RF-pulse 22, provides initial dephasing of the spins in the read direction. This compensation read gradient 51 has half the size of the read gradients 52, 53, 54, 55 and 56.

During the occurrence of a spin-echo signal, the signal is sampled a number of times, 256 is a usual number, as indicated by the sampling arrays 72, 73, 74, 75 and 76 in Figure 2. By means of quadrature detection, each of the samples provides an in-phase and a 90°-phase shifted signal or, alternatively phrased, each sample yields the real and imaginary components of a complex NMR-signal value.

In the preparatory sequence, care has to be taken to avoid negative effects caused by the interference of the desired spin-echo signals with unwanted stimulated echo's. This can be done, for example, by dephasing in the selection direction or intentionally applying a deviation from the indicated timing, thereby deviating from the condition that the size of the nominal gradients in between the excitation and first refocusing RF-pulses is equal to one-half of the size between the refocusing RF-pulses. In the latter case, the stimulated echo and the desired spin-echo signal are not coincident.

Similar to the described influence of eddy currents in the read direction, eddy currents, or other disturbances, also act upon the signal in the slice selection direction. The effect in this direction exhibits itself in the phase of the NMR-signals.

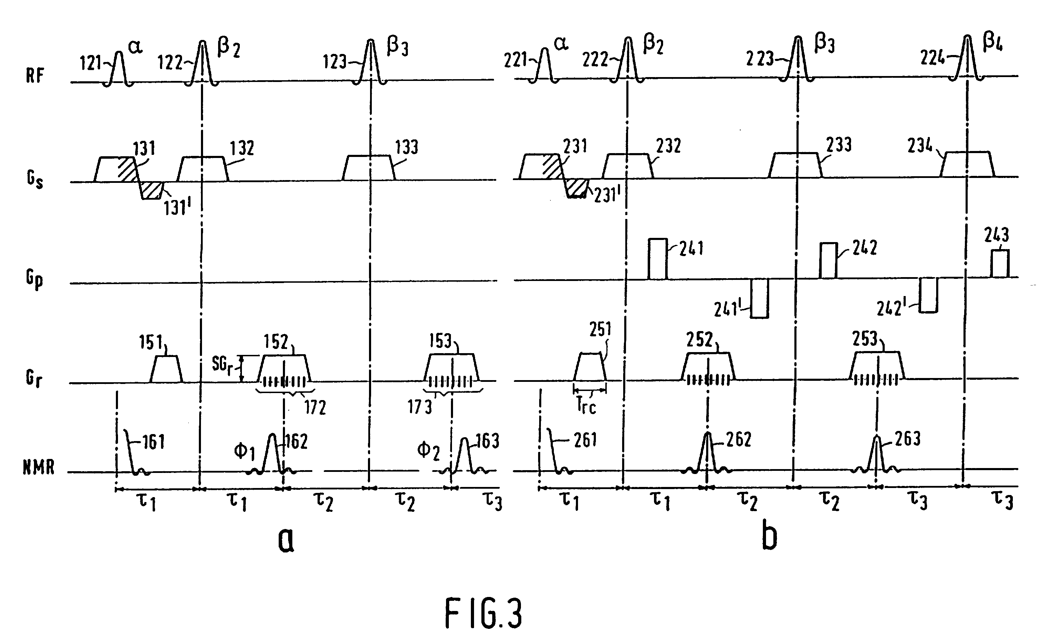

A compensating effect can be achieved by adjusting the phase of the excitation RF-pulse 221 in the measuring sequence by an amount Δφ_{α} = -^{½}(φ₂-φ₁)₁ where φ₂-φ₁ is the difference between the phases φ₁ and φ₂ at the centre of the NMR-signals 162 and 163 in the preparatory sequence (Figure 3). This adjustment of the RF-pulse phase is preferred if a body is imaged by means of two-dimensional images of a plurality of slices. In that case, the variation of the phase across the thickness of the slice is of less importance. Two possible causes of disturbance, phase-distortion in the RF-chain and deviations of the slice selection gradients can be disentangled by measurements having different off-centre positions.

If several slices in the body are measured simultaneously, for example, by generating spin-echo sequences which alternate the frequency of the RF-pulses and/or the value of the selection gradient Gₛ, the method described hereinbefore, allows the determination of the optimum compensation for each of the slices separately. The given procedure of determining the adjustment value by means of a short preparatory sequence is then repeated for each of the selected slices.

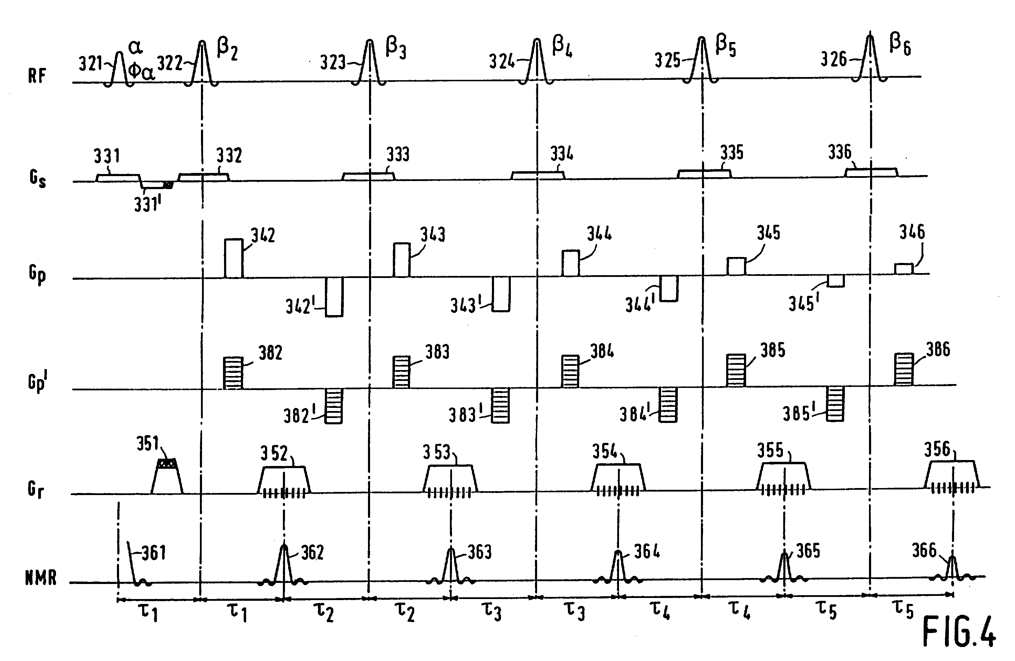

Alternatively to one or more two dimensional measurements in selected slices, a portion of the body can be imaged in three dimensions. In that case the slice selection gradient Gₛ may be adopted for selection of a thick section of the body or even be absent. In addition to the mentioned gradient fields, a second phase encoding gradient magnetic field G_{p'} is applied having a gradient direction perpendicular to the gradient directions of the first phase encoding field Gₚ and the read gradient field Gᵣ. This is illustrated in Figure 4, in which Figure a slice selection gradient Gₛ is supplemented by a second series of phase encoding gradients G_{p'}. As the illustrated sequence, in its other aspects, is identical to the sequence shown in Figure 2, no detailed discussion is given. Like the first phase encoding field Gₚ , the second gradient encoding field is applied as a series of gradient pulses 382, 383, 384, 385, 386, following the RF-pulses and compensating gradient pulses 382', 383', 384', 385', following the spin-echo signals. The way in which the sizes of first and second phase encoding gradient pulses vary can be chosen at will, provided all required combinations of phase encoding gradients in the two directions are present.

The phase of the excitation RF-pulse 321 can be adjusted to tune the phase of the NMR-signals in the centre of the area to be imaged, independent of the influence of disturbing magnetic fields.

## Claims

1. Method for magnetic resonance imaging of a body (7) placed in a stationary and substantially homogeneous main magnetic field, the method including at least one measuring sequence comprising
- the application of an excitation radio-frequency pulse (RF-pulse) (221) for excitation of nuclear dipole moments in at least a portion of the body,
- the application of a plurality of refocusing RF-pulses (222-224) following said excitation RF-pulse (221) and switched gradient magnetic fields (231-234, 241-243, 251-253) for generating position dependent magnetic resonance spin echo signals (262-263) in the excited portion, the method further comprising the steps of
- application of a preparatory sequence comprising an excitation RF-pulse (121), refocusing RF-pulses (122-123) and switched gradient magnetic fields (131-133, 151-153), and measurement of magnetic resonance spin echo signals (162-163) generated in the preparatory sequence the preparatory sequence being applied for generating at least a first and a second magnetic resonance spin echo signal (162, 163), and
- adjustment in the measuring sequence of the initial stage, till the first refocusing RF-pulse (222), and the acquisition stage, subsequent to said initial stage, relative to each other in dependence on a parameter determined from the magnetic resonance spin echo signals (162-163) measured in the preparatory sequence, characterised in that,
- in the measuring sequence, the initial stage is adjusted by adapting the phase of the excitation RF-pulse (221) with respect to the phases of the refocusing RF pulses (222-224) and/or the acquisition stage is adjusted by adapting the phases of the refocusing RF-pulses (222-224) with respect to the phase of the excitation RF-pulse, whereby the amount of the adjustment of the phase of the excitation RF pulse in the initial stage and/or of the phases of the RF refocusing pulses in the acquisition stage is proportional to the difference (φ₁-φ₂) between the phases of said first and second magnetic resonance spin echo signals (162, 163).

2. Method according to the preceding Claim 1, wherein a plurality of sequences comprising RF-pulses and switched gradient magnetic fields are applied, characterised in that at least two different slices of the body are selected and in that the initial stage or the acquisition stage of the measuring sequences are adjusted for each selected slice separately.

3. Apparatus for magnetic resonance imaging of a body (7) placed in a stationary and substantially homogeneous main magnetic field according to a method as claimed in any one of the preceding Claims, the apparatus comprising means (2) for establishing the main magnetic field means (3,4,5) for generating switched gradient magnetic fields superimposed upon the main magnetic field, means (6,8) for radiating RF-pulses towards a body (7) placed in the main magnetic field, control means (12) for steering the generation of the switched gradient magnetic fields and the RF-pulses, and means (6,10) for receiving and sampling magnetic resonance signals generated by sequences of RF-pulses and switched gradient magnetic fields, said control means (12) being arranged to
- apply a preparatory sequence comprising an excitation RF-pulse (121), refocusing RF-pulses (122-123) and switched gradient magnetic fields (131-133, 151-153) for measuring magnetic resonance spin echo signals (162-163),
the preparatory sequence being applied for generating at least a first and a second magnetic resonance spin echo signal (162, 163)
- to apply at least one measuring sequence comprising
the application of an excitation radio-frequency pulse (RF-pulse) (221) for excitation of nuclear dipole moments in at least a portion of the body, and
the application of a plurality of refocusing RF-pulses (222-224) following said excitation RF-pulse (221) and of switched gradient magnetic fields (231-234, 241-243, 251-253) for generating position dependent magnetic resonance spin echo signals (262,263) in the excited portion,
- and to adjust,
- in the measuring sequence, the initial stage, till the first refocusing RF-pulse (222), and the acquisition stage, subsequent to said initial stage, relative to each other in dependence on a parameter determined from the magnetic resonance spin echo signals (162-163) measured in the preparatory sequence, characterised in that
the control means are further arranged
- to adjust, in the measuring sequence, the initial stage by adapting the phase of the excitation RF-pulse (221) with respect to the phases of the refocusing pulses (222-224) and/or to adjust the acquisition phase by adapting the phases of the refocusing RF-pulses (222-224) with respect to the phase of the excitation RF-pulse, whereby the amount of the adjustment of the phase of the excitation RF pulse in the initial stage and/or of the phases of the RF refocusing pulses in the acquisition stage is proportional to the difference (φ₁-φ₂) between the phases of said first and second magnetic resonance spin echo signals (162, 163).

## Patentansprüche

1. Verfahren zur Kernresonanzabbildung eines in ein stationäres und nahezu homogenes Hauptmagnetfeld eingebrachten Körpers (7), wobei das Verfahren zumindest eine Messsequenz enthält, mit
- dem Anlegen eines Anregungshochfrequenzimpulses (HF-Impulses) (221) zur Anregung von Kerndipolmomenten in zumindest einem Teil des Körpers,
- dem Anlegen einer Vielzahl von refokussierenden HF-Impulsen (222-224), die dem genannten Anregungs-HF-Impuls (221) folgen und von geschalteten Gradientenmagnetfeldern (221-234, 241-243, 251-253) zum Generieren von positionsabhängigen Kernresonanz-Spinechosignalen (262-263) in dem angeregten Teil, wobei das Verfahren weiterhin die folgenden Schritte umfasst:
- Anlegen einer vorbereitenden Sequenz mit einem Anregungs-HF-Impuls (121), refokussierenden HF-Impulsen (122-123) und geschalteten Gradientenmagnetfeldern (131-133, 151-153) und Messung von in der vorbereitenden Sequenz generierten Kernresonanz-Spinechosignalen (162-163), wobei die vorbereitende Sequenz zum Generieren von zumindest einem ersten und einem zweiten Kernresonanz-Spinechosignal (162, 163) angelegt wird und
Einstellung der Anfangsstufe in der Messsequenz, bis zum ersten refokussierende HF-Impuls (222), und der Erfassungsstufe, im Anschluss an die genannte Anfangsstufe, relativ zueinander in Abhängigkeit von einem aus den Kernresonanz-Spinechosignalen (162-163) bestimmten, in der vorbereitenden Sequenz gemessenen Parameter, dadurch gekennzeichnet, dass
- in der Messsequenz die Anfangsstufe durch Einstellen der Phase des Anregungs-HF-Impulses (221) in Bezug auf die Phasen der refokussierenden HF-Impulse (222-224) und/oder die Erfassungsstufe durch Anpassen der Phasen der refokussierenden HF-Impulse (222-224) in Bezug auf die Phase des Anregungs-HF-Impulses (221) eingestellt wird, wobei das Maß der Einstellung der Phase des Anregungs-HF-Impulses (221) in der Anfangsstufe und oder der Phasen der refokussierenden HF-Impulse in der Erfassungsstufe proportional zur Differenz (φ₁-φ₂) zwischen den Phasen der genannten ersten und zweiten Kernresonanz-Spinechosignale (162, 163) ist.

2. Verfahren nach Anspruch 1, in dem eine Vielzahl von Sequenzen mit HF-Impulsen und geschalteten Gradientenmagnetfeldern angelegt werden, dadurch gekennzeichnet, dass zumindest zwei verschiedene Schichten des Körper selektiert werden und dass die Anfangsstufe oder die Erfassungsstufe der Messsequenzens für jede selektierte Schicht gesondert eingestellt werden.

3. Gerät zur Kernresonanzabbildung eines in ein stationäres und nahezu homogenes Hauptmagnetfeld eingebrachten Körpers (7) gemäß einem Verfahren nach einem der vorhergehenden Ansprüche, wobei das Gerät Mittel (2) zum Aufbauen des Haupt-magnetfeldes, Mittel (3,4,5) zum Erzeugen von dem Hauptmagnetfeld überlagerten geschalteten Gradientenmagnetfeldern, Mittel (6,8) zum Abstrahlen von HF-Impulsen hin zu einem in das Hauptmagnetfeld eingebrachten Körper (7), Steuerungsmittel (12) zum Ansteuern der Erzeugung der geschalteten Gradientenmagnetfelder und der HF-Impulse, und Mittel (6,10) zum Empfangen und Abtasten von Kernresonanzsignalen, die von Sequenzen von HF-Impulsen und geschalteten Gradientenmagnetfeldern generiert worden sind, umfasst, wobei die genannten Steuerungsmittel (12) ausgebildet sind, um
- eine vorbereitende Sequenz mit einem Anregungs-HF-Impuls (121), refokussierenden HF-Impulsen (122-123) und geschalteten Gradientenmagnetfeldern (131-133, 151-153) zum Messen Kernresonanz-Spinechosignale (162-163) anzulegen,
wobei die vorbereitende Sequenz angelegt wird, um zumindest ein erstes und ein zweites Kernresonanz-Spinechosignal (162, 163) zu erzeugen,
- zumindest eine Messsequenz anzulegen, mit
dem Anlegen eines Anregungshochfrequenzimpulses (HF-Impuls) (221) zur Anregung von Kerndipolmomenten in zumindest einem Teil des Körpers und
dem Anlegen einer Vielzahl von refokussierenden HF-Impulsen (222-224), die dem genannten Anregungs-HF-Impuls (221) folgen und von geschalteten Gradientenmagnetfeldern (221-234, 241-243, 251-253) zum Generieren von positionsabhängigen Kernresonanz-Spinechosignalen (262,263) in dem angeregten Teil,
- und um
- in der Messsequenz die Anfangsstufe, bis zum ersten refokussierende HF-Impuls (222), und die Erfassungsstufe, im Anschluss an die genannte Anfangsstufe, relativ zueinander in Abhängigkeit von einem aus den Kernresonanz-Spinechosignalen (162-163) bestimmten, in der vorbereitenden Sequenz gemessenen Parameter einzustellen, dadurch gekennzeichnet, dass
die Steuerungsmittel weiterhin ausgebildet sind
- zum Einstellen, in der Messsequenz, der Anfangsstufe durch Anpassen der Phase des Anregungs-HF-Impulses (221) in Bezug auf die Phasen der refokussierenden HF-Impulse (222-224) und/oder zum Einstellen der Erfassungsstufe durch Anpassen der Phasen der refokussierenden HF-Impulse (222-224) in Bezug auf die Phase des Anregungs-HF-Impulses (221), wobei das Maß der Einstellung der Phase des Anregungs-HF-Impulses (221) in der Anfangsstufe und/oder der Phasen der refokussierenden HF-Impulse in der Erfassungsstufe proportional zur Differenz (φ₁-φ₂) zwischen den Phasen der genannten ersten und zweiten Kernresonanz-Spinechosignale (162, 163) ist.

## Revendications

1. Procédé d'imagerie par résonance magnétique d'un corps (7) placé dans un champ magnétique principal statique et pratiquement homogène, le procédé incluant au moins une séquence de mesure comprenant :
- l'application d'une impulsion de radiofréquence (impulsion RF) d'excitation (221) pour exciter des moments nucléaires dipolaires dans au moins une partie du corps;
- l'application d'une pluralité d'impulsions RF de refocalisation (222 à 224) suite à ladite impulsion RF d'excitation (221) et de champs magnétiques à gradient commuté (221 à 234, 241 à 243, 251 à 253) pour produire des signaux d'écho de spin de résonance magnétique dépendant de la position (262, 263) dans la partie excitée, le procédé comprenant en outre les étapes suivantes :
- l'application d'une séquence préparatoire comprenant une impulsion RF d'excitation (121), des impulsions RF de refocalisation (122 à 123) et des champs magnétiques à gradient commuté (131 à 133, 151 à 153), et la mesure de signaux d'écho de spin de résonance magnétique (162, 163) produits dans la séquence préparatoire,
la séquence préparatoire étant appliquée pour produire au moins un premier et un deuxième signaux d'écho de spin de résonance magnétique (162, 163), et
- le réglage dans la séquence de mesure du stade initial, jusqu'à la première impulsion RF de refocalisation (222), et du stade d'acquisition, suivant ledit stade initial, l'un par rapport à l'autre en fonction d'un paramètre déterminé à partir des signaux d'écho de spin de résonance magnétique (162, 163) mesurés dans la séquence préparatoire,
caractérisé en ce que
- dans la séquence de mesure, le stade initial est réglé en adaptant la phase de l'impulsion RF d'excitation (221) par rapport aux phases des impulsions RF de refocalisation (222 à 224), et/ou en ce que le stade d'acquisition est réglé en adaptant les phases des impulsions RF de refocalisation (222 à 224) par rapport à la phase de l'impulsion RF d'excitation, le degré de réglage de la phase de l'impulsion RF d'excitation dans le stade initial et/ou des phases des impulsions RF de refocalisation dans le stade d'acquisition étant proportionnelle à la différence (φ₁-φ₂) entre les phases desdits premier et deuxième signaux d'écho de spin de résonance magnétique (162, 163).

2. Procédé suivant la revendication 1 précédente, dans lequel une pluralité de séquences comprenant des impulsions RF et des champs magnétiques à gradient commuté est appliquée, caractérisé en ce qu'au moins deux tranches différentes du corps sont sélectionnées et en ce que le stade initial ou le stade d'acquisition des séquences de mesure est réglé séparément pour chaque tranche sélectionnée.

3. Appareil d'imagerie par résonance magnétique d'un corps (7) placé dans un champ magnétique principal statique et pratiquement homogène suivant un procédé tel que revendiqué dans l'une quelconque des revendications précédentes, l'appareil comprenant des moyens (2) pour établir le champ magnétique principal, des moyens (3, 4, 5) pour produire des champs magnétiques à gradient commuté superposés au champ magnétique principal, des moyens (6, 8) pour émettre des impulsions RF vers un corps (7) placé dans le champ magnétique principal, des moyens de commande (12) pour régir la production. Les champs magnétiques à gradient commuté et les impulsions RF, et des moyens (6, 10) pour recevoir et échantillonner des signaux de résonance magnétique produits par des séquences d'impulsions RF et de champs magnétiques à gradient commuté, lesdits moyens de commande (12) étant agencés pour
- appliquer une séquence préparatoire comprenant une impulsion RF d'excitation (121), des impulsions RF de refocalisation (122, 123) et des champs magnétiques à gradient commuté (131 à 133, 151 à 153) pour mesurer des signaux d'écho de spin de résonance magnétique (162, 163),
la séquence préparatoire étant appliquée pour produire au moins un premier et un deuxième signaux d'écho de spin de résonance magnétique (162, 163),
- appliquer au moins une séquence de mesure comprenant
l'application d'une impulsion de radiofréquence (impulsion RF) d'excitation (221) pour exciter des moments nucléaires dipolaires dans au moins une partie du corps, et
l'application d'une pluralité d'impulsions RF de refocalisation (222 à 224) suite à ladite impulsion RF d'excitation (221) et de champs magnétiques à gradient commuté (231 à 234, 241 à 243, 251 à 253) pour produire des signaux d'écho de spin de résonance magnétique dépendant de la position (262, 263) dans la partie excitée, et
- régler, dans la séquence de mesure, le stade initial, jusqu'à la première impulsion RF de refocalisation (222), et le stade d'acquisition suivant ledit stade initial, l'un par rapport à l'autre en fonction d'un paramètre déterminé à partir des signaux d'écho de spin de résonance magnétique (162, 163) mesurés dans la séquence préparatoire,
caractérisé en ce que
les moyens de commande sont en outre propres à
- régler dans la séquence de mesure, le stade initial en adaptant la phase de l'impulsion RF d'excitation (221) par rapport aux phases des impulsions de refocalisation (222 à 224), et/ou à régler le stade d'acquisition en adaptant les phases des impulsions RF de refocalisation (222 à 224) par rapport à la phase de l'impulsion RF d'excitation, le degré de réglage de la phase de l'impulsion RF d'excitation dans le stade initial et/ou des phases des impulsions RF de refocalisation dans le stade d'acquisition étant proportionnel à la différence (φ₁-φ₂) entre les phases desdits premier et deuxième signaux d'écho de spin de résonance magnétique (162, 163).
